Europäisches Patentamt

(19) European Patent Office

Office européen des brevets

(11) Veröffentlichungsnummer: **0 212 477**
**B1**

(12) **EUROPÄISCHE PATENTSCHRIFT**

(45) Veröffentlichungstag der Patentschrift:
27.12.89

(51) Int. Cl.⁴: **H01L 29/08, H01L 29/12**

(21) Anmeldenummer: 86110944.5

(22) Anmeldetag: 07.08.86

(54) Leistungstransistoranordnung.

(30) Priorität: 08.08.85 DE 3528566

(43) Veröffentlichungstag der Anmeldung:
04.03.87 Patentblatt 87/10

(45) Bekanntmachung des Hinweises auf die Patenterteilung:
27.12.89 Patentblatt 89/52

(84) Benannte Vertragsstaaten:
AT DE FR GB IT NL SE

(56) Entgegenhaltungen:
FR-A- 2 314 582
GB-A- 1 237 148
US-A- 4 266 236
US-A- 4 417 265

(73) Patentinhaber: Siemens Aktiengesellschaft,
Wittelsbacherplatz 2, D-8000 München 2(DE)

(72) Erfinder: Mahrla, Peter, Dipl.-Phys.,
Geiselgasteigstrasse 96, D-8000 München 90(DE)

**Beschreibung**

Die Erfindung betrifft eine Leistungstransistoranordnung nach dem Oberbegriff des Patentanspruchs 1.

Die an einen Leistungstransistor zu stellenden Anforderungen umfassen neben einer hohen Stromverstärkung selbst bei hohen Stromwerten und einer niedrigen Sättigungsspannung auch die Sicherheit gegenüber einem sekundären Durchbruch sowie hohe Zuverlässigkeit über die gesamte Lebensdauer bei gleichzeitig kleinstmöglicher Größe des Transistors.

Eine hohe Stromverstärkung erreicht man durch einen großen derart ausgelegten Emitterbereich, daß die Stromdichte im Emitterbereich bei jedem Stromwert gleichmäßig verteilt ist. Die Höhe der Sättigungsspannung wird wesentlich vom Kollektorserienwiderstand bestimmt, der sich durch konstruktive Maßnahmen z.B. zur Verringerung des Stromweges reduzieren läßt. Zuverlässigkeit und Größe des Leistungstransistors bei gleichzeitiger Vermeidung eines sekundä-ren Durchbruchs werden im wesentlichen durch die Stromverteilung beeinflußt.

Bei großflächigen Leistungstransistoren ist eine gleichmäßige Stromverteilung über den gesamten Transistor für die Stromtragfähigkeit und Belastbarkeit von entscheidender Bedeutung. Da es üblich ist, zur Erfüllung der Anforderungen an einen Leistungstransistor viele paralellgeschaltete Einzeltransistoren zu verwenden, ist für die gleichmäßige Stromverteilung in erster Linie die Basis-Emitter-Spannung der einzelnen Transistoren maßgebend. Nicht zu vernachlässigen sind dabei Spannungsabfälle auf den stromzuführenden Leitbahnen, die eine unterschiedliche Basis-Emitter-Spannung der verschiedenen Einzeltransistoren zur Folge haben können.

Weiterhin übt die Temperaturverteilung im Leistungstransistor einen zusätzlichen Einfluß auf die Stromverteilung aus. Bei fester Basis-Emitter-Spannung nimmt die Kollektorstromdichte in einem Transistor mit steigender Temperatur aufgrund des negativen Temperaturkoeffizienten des Basis-Emitter-Übergangs stark zu. Da die Basis- und Emitterbereiche der einzelnen Transistoren über die stromzuführenden Leitbahnen parallel geschaltet sind, ist die Stromdichte an den heißesten Stellen am höchsten. Diese lokal hohe Stromdichte führt wiederum zu einer verstärkten Erwärmung und damit zu einer thermischen Mitkopplung, die eine starke Konzentration des Stroms auf die heißesten Transistorbereiche hervorruft (hot spots). Belastbarkeit und Zuverlässigkeit des Transistors ergeben sich aus einem zulässigen Temperaturgrenzwert, der nicht überschritten werden darf.

Üblicherweise werden deshalb Emitterwiderstände für die einzelnen Teil-Leistungstransistoren vorgesehen, die eine Stromgegenkopplung und eine gleichmäßigere Stromverteilung bewirken. Dabei wird der Wert der Emitterwiderstände üblicherweise so groß gewählt, daß die Spannungsabfälle entlang der Leitbahnzuführungen zu vernachlässigen sind. Die DE-A 26 25 989 gibt eine Möglichkeit an, verschiedene aus Einzeltransistoren bestehende Gruppen so zu kompensieren, daß für jede Gruppe gleiche Arbeitsbedingungen für die Emitter bestehen. Dazu werden Verbindungszonen zwischen einer Emitterkontakt- und einer aktiven Emitterzone in der Parallelschaltung der sukzessiven Einzeltransistoren mit progressiv sich verändernden Breiten vorgesehen.

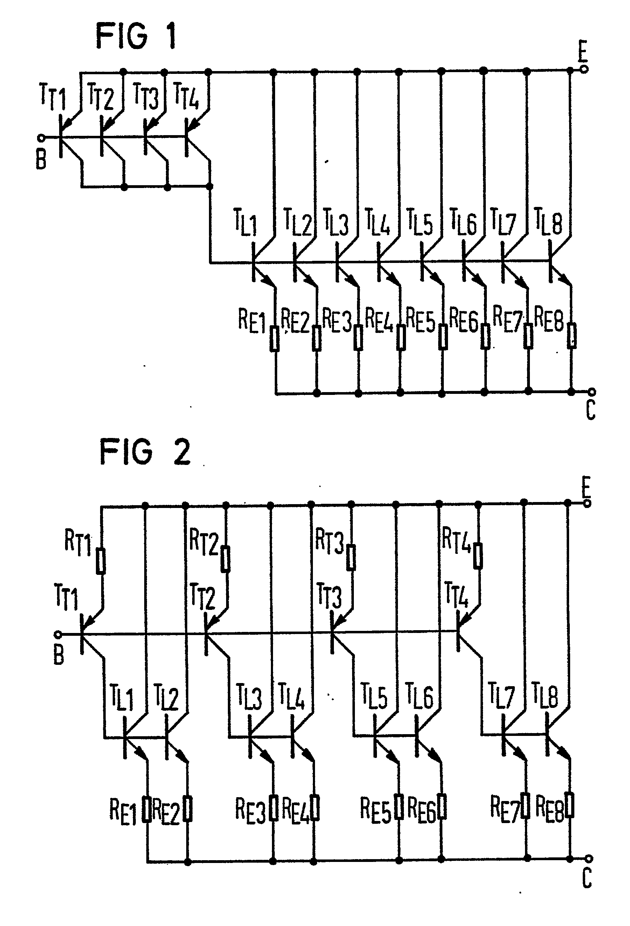

Fig. 1 zeigt das elektrische Ersatzschaltbild eines von einem pnp-Treibertransistor angesteuerten npn-Leistungstransistors, der als Quasi-pnp-Leistungstransistor bezeichnet wird. Der Treibertransistor besteht aus den Teiltreibertransistoren $T_{T1}$ bis $T_{T4}$ und der Leistungstransistor aus den Teil-Leistungstransistoren $T_{L1}$ bis $T_{L8}$. Jeder der Teil-Leistungstransistoren besitzt einen eigenen Emitter-Widerstand $R_{E1}$ bis $R_{E8}$.

Die Eingangskreise der Teil-Treibertransistoren sind parallel geschaltet, wobei die Basen der Teiltransistoren mit der Steuerklemme B und ihre Emitter mit der Anschlußklemme E verbunden sind. Ebenfalls parallelgeschaltet sind die Ausgangskreise der Teil-Leistungstransistoren, deren Kollektoren mit der Ausgangsklemme E und deren Emitter über die Emitterwiderstände $R_{E1}$ bis $R_{E8}$ an die Ausgangsklemme C angeschlossen sind. Die Kollektoren der Teil-Treibertransistoren $T_{T1}$ bis $T_{T4}$ sind zusammengeführt und steuern die durchverbundenen Basen der Teil-Leistungstransistoren $T_{L1}$ bis $T_{L8}$ an. In der physikalischen Realisierung des Ersatzschaltbildes nach Fig. 1 dient die Klemme B als Basisanschluß, die Klemme E als Emitter- und die Klemme C als Kollektoranschluß. Quasi-pnp-Leistungstransistoren werden gegenüber echten pnp-Transistoren oft bevorzugt, weil sich npn-Leistungstransistoren mit der gegenüber einer lateralen Struktur Vorteile bietenden vertikalen Transistorstruktur leichter realisieren lassen und z.B. in Verbindung mit integrierten Schaltkreisen mit komplementären Leistungstransistoren sich gleiche Leistungstransistoren vom npn-Typ verwenden lassen.

Zwar werden in der Leistungstransistoranordnung nach Fig. 1 die Teil-Leistungstransistoren nicht von einer Spannungsquelle, sondern vom Kollektorstrom der Teil-Treibertransistoren angesteuert, aber trotzdem können Spannungsabfälle an den Basis-Emitterübergängen der Teil-Leistungstransistoren auftreten. In der Regel wird z.B. der den Kollektoren der Teil-Treibertransistoren geometrisch nächste Transistor den größten Basisstrom ziehen und damit den größten Basis-Emitterspannungsabfall hervorrufen. Auf diese Weise ergibt sich unterschiedliche Stromverteilung auf die einzelnen Teil-Leistungstransistoren.

Der Erfindung liegt die Aufgabe zugrunde, eine Leistungstransistoranordnung mit mehreren Teil-Leistungstransistoren und gleichmäßiger Stromverteilung anzugeben.

Diese Aufgabe wird bei einer Leistungstransistoranordnung der eingangs genannten Art erfindungsgemäß durch die Merkmale des kennzeichnenden Teils des Patentanspruchs 1 gelöst.

Weitere Ausgestaltungen des Erfindungsgedankens sind in Unteransprüchen gekennzeichnet.

Die Erfindung wird im folgenden anhand von in den Figuren der Zeichnung dargestellten Ausführungsbeispielen näher erläutert.

Es zeigt:

Fig. 2 ein elektrisches Ersatzschaltbild einer Quasi-pnp-Leistungstransistoranordnung und

Fig. 3 ein Teilersatzschaltbild einer topologisch flächengünstigen Quasi-pnp-Leistungstransistoranordnung.

Gemäß Fig. 2, in der gleiche Elemente wie in Fig. 1 mit gleichen Bezugszeichen versehen sind, werden erfindungsgemäß die Teil-Leistungstransistoren und die Teil-Treibertransistoren in einzelne, einander zugeordnete Segmente mit getrennten Basisstromführungen für die Leistungstransistorsegmente aufgeteilt. Die Eingangskreise der Teil-Treibertransistoren $T_{T1}$ bis $T_{T4}$ sind parallelgeschaltet und mit ihren Basen an der Steuerklemme B angeschlossen, während ihre Emitter über Emitterwiderstände $R_{T1}$ bis $R_{T4}$ mit der Ausgangsklemme E der Anordnung verbunden sind. Ebenso sind die Ausgangskreise der Teil-Leistungstransistoren $T_{L1}$ bis $T_{L8}$ mit ihren jeweiligen Emitterwiderständen $R_{E1}$ bis $R_{E8}$ parallelgeschaltet, wobei ihre Kollektoren an der Ausgangsklemme E und ihre Emitter über die Emitterwiderstände an der Ausgangsklemme C angeschlossen sind.

Im Unterschied zur Anordnung nach Fig. 1 sind die Kollektoren der Teil-Treibertransistoren nicht an den mit den Basen der Teil-Leistungstransistoren verbundenen Knotenpunkt angeschlossen, sondern jeder Kollektor jedes Teil-Treibertransistors ist separat herausgeführt und mit einer oder mehreren Basen eines Leistungstransistorsegments verbunden. In Fig. 2 enthält ein Leistungstransistorsegment zwei Teil-Leistungstransistoren und ein Treibertransistorsegment einen Teil-Treibertransistor. Es liegt jedoch im Rahmen der Erfindung, daß die Treibertransistorsegmente mehr als einen Teil-Treiber transistor und die Leistungstransistorsegmente sowohl nur einen als auch mehrere Teil-Leistungstransistoren enthalten können.

Die einzelnen Leistungstransistorsegmente erhalten also erfindungsgemäß ihren Basisstrom von Segmenten eines jeweils zugeordneten einzelnen Treibertransistorsegments. Damit wird für die Stromverteilung unter den npn-Leistungstransistorsegmenten nicht mehr deren Basis-Emitter-Spannung, sondern nur noch der von dem Treibertransistorsegment zugeführte Basisstrom und die Stromverstärkung maßgebend. Eine optimale Basisstromansteuerung der Leistungstransistorsegmente wird aber mit erfindungsgemäßen Maßnahmen erzielt.

Neben der Aufteilung der Teil-Leistungstransistoren und der Teil-Treibertransistoren in einzelne Segmente mit jeweils getrennten Basisstromführungen für die Leistungstransistorsegmente ist es weiterhin vorteilhaft, jedes pnp-Treibertransistorsegments dem zugehörigen npn-Leistungstransistorsegments anzupassen. Die Anpassung kann sowohl hinsichtlich der Geometrie und der Größe als auch hinsichtlich der Leitbahnzuführungen und der Widerstände erfolgen. So ermöglichen es die erfindungsgemäßen Merkmale, einen kleineren Treibertransistor vorzusehen. Darüberhinaus ist es vorteilhaft, wie in Fig. 2 dargestellt, Emitterwiderstände $R_{T1}$ bis $R_{T4}$ in den Emitterzuleitungen der pnp-Treibertransistorsegmente vorzusehen, die eine Stromgegenkopplung für eine zusätzliche Stromstabilisierung der pnp-Treibertransistorsegmente untereinander bewirken.

Gemäß Fig. 2 fließen der Kollektorstrom des npn-Leistungstransistors und der Emitterstrom des pnp-Treibertransistors über eine gemeinsame Leitbahnzuführung. Durch den großen Kollektorstrom des npn-Leistungstransistors entsteht entlang der Leitbahn ein Spannungsabfall, durch den die Basis-Emitter-Spannung der pnp-Treibertransistorsegmente beeinflußt wird. Es ist somit vorteilhaft, zur Erzielung einer optimalen Stromverteilung eine Aufteilung der beiden Leitbahnzuführungen zu den Emittern der Teil-Treibertransistoren einerseits und zu den Kollektoren der Teil-Leistungstransistoren andererseits vorzusehen.

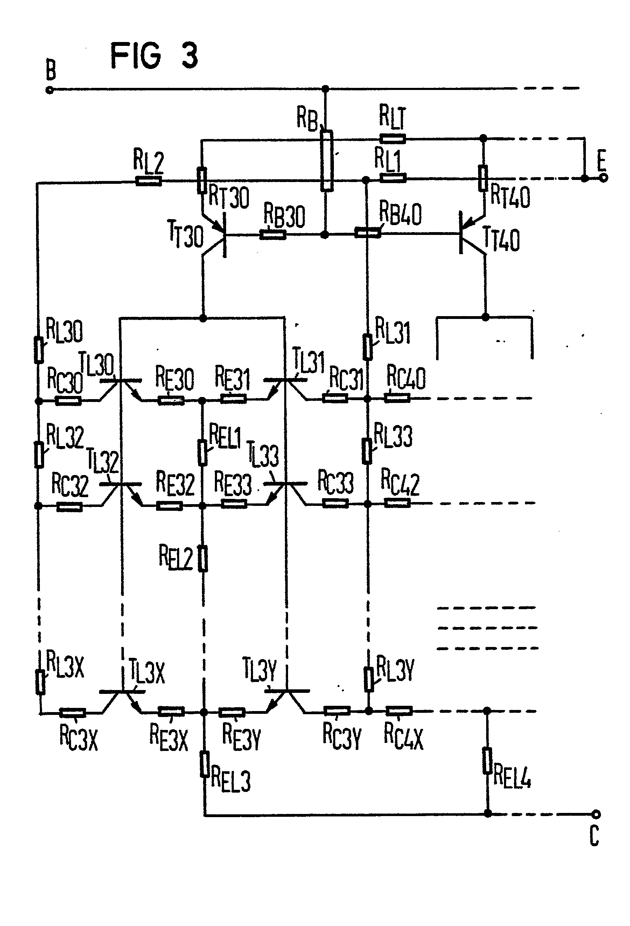

Fig. 3 zeigt ein elektrisches Teil-Ersatzschaltbild eines Quasi-pnp-Leistungstransistors. Herausgegriffen sind lediglich zwei Teil-Treibertransistoren $T_{T30}$ und $T_{T40}$ sowie ein Teil der zum Treibertransistor $T_{T30}$ gehörenden Teil-Leistungstransistoren vom npn-Typ. Weitere Anschlußleitungen bzw. weitere Teil-Treibertransistoren und weitere Teil-Leistungstransistoren sind durch punktierte oder strichlierte Linien angedeutet. Die Leitbahnwiderstände sind als diskrete Ersatzwiderstände herausgezeichnet.

Die Basen der Teil-Treibertransistoren $T_{T30}$ und $T_{T40}$ werden über einen gemeinsamen Basisvorwiderstand $R_B$ und einen der jeweiligen Basis direkt vorgeschalteten Widerstand $R_{B30}$ und $R_{B40}$ mit der Steuerklemme B der Anordnung verbunden. Weitere Teil-Treibertransistoren können zu dieser Anordnung parallel liegen. Den Emittern der Teil-Treibertransistoren $T_{T30}$ bzw. $T_{T40}$ sind die Emitterwiderstände $R_{T30}$ bzw. $R_{T40}$ vorgeschaltet, die über eine separate Leitbahnzuführung mit der Anschlußklemme E verbunden sind. Zwischen den emitterabgewandten Anschlüssen der Emitterwiderstände $R_{T30}$ und $R_{T40}$ liegt dabei der Leitbahnwiderstand $R_{LT}$.

Der Kollektor des Treibertransistors $T_{T30}$ ist mit den parallel liegenden Basen der Teil-Leistungstransistoren $T_{L30}$ bis $T_{L33}$ sowie $T_{L3X}$ und $T_{L3Y}$ verbunden. Dabei liegen die Basen der Teil-Leistungstransistoren $T_{L30}$, $T_{L32}$ bis $T_{L3X}$ hintereinander, während in einem zweiten Zweig die Basen der Teil-Leistungstransistoren $T_{L31}$, $T_{L33}$ bis $T_{L3Y}$ hintereinander liegen. Den Emittern der Teil-Leistungstransistoren ist jeweils ein Emitterwiderstand $R_{E30}$ bis $R_{E33}$ sowie $R_{E3X}$ und $R_{E3Y}$ so zugeordnet, daß bei jeweils die Emitterwiderstände eines Teil-Leistungstransistors mit geradem und ungeradem Index zu einem Knotenpunkt zusammenführen. Die einzelnen Knotenpunkte sind über eine gemeinsame Leitbahnzuführung mit der Anschlußklemme C der Transistoranordnung verbunden, wobei zwischen den einzelnen Knotenpunkten die Leitbahnwiderstände $R_{EL1}$, $R_{EL2}$ bis $R_{EL3}$ liegen.

In der Anordnung gemäß Fig. 3 besitzen die Teil-Leistungstransistoren jeweils zugeordnete Kollektorwiderstände $R_{C30}$ bis $R_{C33}$ sowie $R_{C3X}$ und $R_{C3Y}$. Die kollektorabgewandten Anschlüsse der Kollektorwiderstände der TeilLeistungstransistoren sind jeweils mit einer Leitbahnzuführung verbunden, die zur Anschlußklemme E führt. Ausgehend von der Anschlußklemme E ist der Kollektorwiderstand $R_{C31}$ über in Fig. 3 nicht gezeichnete Leitbahnwiderstände sowie den gezeichneten Leitbahnwiderstand $R_{L1}$ und $R_{L31}$ versorgt. Der Kollektorwiderstand $R_{C30}$ ist mit der Anschlußklemme E über nicht gezeichnete Leitbahnwiderstände sowie die gezeichneten Leitbahnwiderstände $R_{L1}$, $R_{L2}$ und $R_{L30}$ versorgt, wobei die jeweiligen Leitbahnwiderstände natürlich in Reihe geschaltet sind. Zwischen den kollektorabgewandten Anschlüssen der Kollektorwiderstände der Teil-Leistungstransistoren ist jeweils der Leitbahnwiderstand $R_{L32}$, $R_{L33}$ sowie $R_{L3X}$ und $R_{L3Y}$ gezeichnet. Um das Schaltschema zu verdeutlichen sind Kollektorwiderstände $R_{C40}$, $R_{C42}$ und $R_{C4X}$ sowie ein Leitbahnwiderstand $R_{EL4}$, die zum Teil-Treibertransistor $T_{T40}$ gehören dargestellt. Die zum Teil-Treibertransistor $T_{T40}$ gezeichneten Kollektorwiderstände der Teil-Leistungstransistoren werden über die gleiche Leitbahnzuführung wie die Kollektorwiderstände der Teil-Treibertransistoren mit ungeraden Indizes an die Anschlußklemme E angeschlossen und versorgt.

Gemäß Fig. 3 sind somit die Leitbahnzuführungen für die Emitter der Teil-Treibertransistoren und die Kollektoren der Teil-Leistungstransistoren über separate Zuführungen mit der Anschlußklemme E verbunden. Werden die Emitterwiderstände der pnp-Treibertransistorsegmente als diffundierte Widerstände ausgeführt, so kann die breite Kollektorstromzuleitung der npn-Leistungstransistorsegmente als metallische Leitbahn über die diffundierten Widerstände hinweggeführt werden.

Gemäß Fig. 3 ist es weiterhin vorteilhaft, Basisvorwiderstände für die Teil-Treibertransistoren bzw. die Treibertransistorsegmente vorzusehen. Diese Vorwiderstände dienen ebenfalls zur Verbesserung der Stromverteilung, indem sie aufgrund ihres positiven Temperaturkoeffizienten den negativen Temperaturkoeffizienten des Basis-Emitter-Übergangs der Teil-Treibertransistoren bei einer Temperaturänderung kompensieren. Auf diese Weise wird dafür gesorgt, daß die Teil-Treibertransistoren bzw. die Treibertransistorsegmente jeweils den gleichen Steuerstrom erhalten. Diese Basisvorwiderstände der Teil-Treibertransistoren bzw. Treibertransistorsegmente können ebenfalls als diffundierte Widerstände ausgebildet werden, über die metallische Leitbahnen hinwegführen können.

Somit läßt sich bei einem integrierten Quasi-pnp-Leistungstransistor eine flächengünstige Topologie realisieren, wie sie gemäß Fig.3 zeichnerisch im Ersatzschaltbild angedeutet ist.

Die gleichen Merkmale kennzeichnen einen erfindungsgemäßen Quasi-npn-Leistungstransistor, bei dem die Teil-Treibertransistoren vom npn-Typ und die Teil-Leistungstransistoren vom pnp-Typ sind.

## Patentansprüche

1. Leistungstransistoranordnung mit mehreren Teil-Leistungstransistoren eines Typs ($T_{L1}$ bis $T_{L8}$; $T_{L30}$ bis $T_{L33}$, $T_{L3X}$, $T_{L3Y}$) mit jeweils einem Emitterwiderstand ($R_{E1}$ bis $R_{E8}$; $R_{E30}$ bis $R_{E33}$, $R_{E3X}$, $R_{E3Y}$), deren Ausgangskreise parallel an Ausgangsklemmen (E, C) der Anordnung geschaltet sind, und mit mehreren Teil-Treibertransistoren vom anderen Typ ($T_{T1}$ bis $T_{T4}$; $T_{T30}$, $T_{T40}$) mit parallelgeschalteten Eingangskreisen, deren Basen mit der Steuerklemme (B) der Anordnung, deren Emitter mit der an die Kollektoren der die Teil-Leistungstransistoren ($T_{L1}$ bis $T_{L8}$; $T_{L30}$ bis $T_{L33}$, $T_{L3X}$, $T_{L3Y}$) geschalteten Ausgangsklemme (E) der Anordnung und deren Kollektoren mit den Basen der Teil-Leistungstransistoren ($T_{L1}$ bis $T_{L8}$ ; $T_{L30}$ bis $T_{L33}$, $T_{L3X}$, $T_{L3Y}$) verbunden sind, **dadurch gekennzeichnet, daß** die Teil-Leistungstransistoren ($T_{L1}$ bis $T_{L8}$; $T_{L30}$ bis $T_{L33}$, $T_{L3X}$, $T_{L3Y}$) und die Teil-Treibertransistoren ($T_{T1}$ bis $T_{T4}$ ; $T_{T30}$, $T_{T40}$) in einzelne, einander zugeordnete Segmente ($T_{T1}$, $T_{L1}$, $T_{L2}$; $T_{T2}$, $T_{L3}$, $T_{L4}$; $T_{T3}$, $T_{L5}$, $T_{L6}$; $T_{T4}$, $T_{L7}$, $T_{L8}$; $T_{T30}$, $T_{L30}$ bis $T_{L33}$, $T_{L3X}$, $T_{L3Y}$) mit getrenntem Basisstromzuführungen für die Leistungstransistorsegmente ($T_{L1}$, $T_{L2}$; $T_{L3}$, $T_{L4}$; $T_{L5}$, $T_{L6}$; $T_{L7}$, $T_{L8}$; $T_{L30}$ bis $T_{L33}$, $T_{L3X}$, $T_{L3Y}$) aufgeteilt sind.

2. Leistungstransistoranordnung nach Anspruch 1, **dadurch gekennzeichnet, daß** jedes Treibertransistorsegment einen Teil-Treibertransistor ($T_{T1}$, $T_{T2}$, $T_{T3}$, $T_{T4}$; $T_{T30}$, $T_{T40}$) und jedes Leistungstransistorsegment mindestens einen Teil-Leistungstransistor ($T_{L1}$, $T_{L2}$; $T_{L3}$, $T_{L4}$; $T_{L5}$, $T_{L6}$; $T_{L7}$, $T_{L8}$; $T_{L30}$ bis $T_{L33}$,$T_{L3X}$, $T_{L3Y}$) aufweist.

3. Leistungstransistoranordnung nach Anspruch 1 oder 2, **dadurch gekennzeichnet, daß** jedes Treibertransistorsegment dem zugeordneten Leistungstransistorsegment angepaßt ist.

4. Leistungstransistoranordnung nach Anspruch 1 bis 3, **dadurch gekennzeichnet, daß** die Teil-Treibertransistoren ($T_{T1}$, $T_{T2}$, $T_{T3}$ , $T_{T4}$; $T_{T30}$, $T_{T40}$) über Emitterwiderstände ($R_{T1}$, $R_{T2}$, $R_{T3}$, $R_{T4}$; $R_{T30}$, $R_{T40}$) mit der an die Kollektoren der Teil-Leistungstransistoren ($T_{L1}$ bis $T_{L8}$; $T_{L30}$ bis $T_{L33}$, $T_{L3X}$, $T_{L3Y}$) geschalteten Ausgangsklemme (E) der Anordnung verbunden sind.

5. Leistungstransistoranordnung nach Anspruch 1 bis 4, **dadurch gekennzeichnet, daß** die Emitter der Teil-Treibertransistoren ($T_{T1}$ bis $T_{T4}$; $T_{T30}$, $T_{T40}$) und die Kollektoren der Teil-Leistungstransistoren ($T_{L1}$ bis $T_{L8}$; $T_{L30}$ bis $T_{L33}$, $T_{L3X}$, $T_{L3Y}$) über jeweils getrennte Leitbahnen mit der entsprechenden Ausgangsklemme (E) der Anordnung verbunden sind.

6. Leistungstransistoranordnung nach Anspruch 1 bis 5, **dadurch gekennzeichnet, daß** die Emitter der Teil-Treibertransistoren ($T_{T1}$ bis $T_{T4}$ ; $T_{T30}$, $T_{T40}$) und die Kollektoren der Teil-Leistungstransistoren ($T_{L1}$ bis $T_{L8}$; $T_{L30}$ bis $T_{L33}$, $T_{L3X}$,$T_{L3Y}$) jeweils über eine sich zu den einzelnen Teil-Transistoren verzweigende gemeinsame Leitbahn mit der entsprechenden Ausgangsklemme (E) der Anordnung verbunden sind.

7. Leistungstransistoranordnung nach Anspruch 1 bis 6, **dadurch gekennzeichnet**, daß die Emitterwiderstände ($R_{E1}$ bis $R_{E8}$, $R_{T1}$ bis $R_{T4}$; $R_{E30}$ bis $R_{E33}$, $R_{E3X}$, $R_{E3Y}$, $R_{T30}$, $R_{T40}$) als Diffusionswiderstände gebildet und topologisch so angeordnet sind, daß die Leitbahnen der Kollektorzuführungen der Teil-Leistungstransistoren ($T_{L1}$ bis $T_{L8}$; $T_{L30}$ bis $T_{L33}$, $T_{L3X}$, $T_{L3Y}$) über sie hinwegführen.

8. Leistungstransistoranordnung nach Anspruch 1 bis 7, **dadurch gekennzeichnet**, daß die Kollektoren der Teil-Leistungstransistoren ($T_{L30}$ bis $T_{L33}$, $T_{L3X}$, $T_{L3X}$) über Kollektorwiderstände ($R_{C30}$ bis $R_{C33}$, $R_{C3X}$, $R_{C3Y}$) mit der entsprechenden Ausgangsklemme (E) der Anordnung verbunden sind.

9. Leistungstransistoranordnung nach Anspruch 1 bis 8, **dadurch gekennzeichnet**, daß die Basen der Teil-Treibertransistoren ($T_{T30}$, $T_{T40}$) über Basisvorwiderstände ($R_B$, $R_{B30}$, $R_{B40}$) mit der Steuerklemme (B) der Anordnung verbunden sind.

10. Leistungstransistoranordnung nach Anspruch 1 bis 9, **dadurch gekennzeichnet**, daß die Kollektorwiderstände ($R_{C30}$ bis $R_{C33}$, $R_{C3X}$, $R_{C3Y}$) der Teil-Leistungstransistoren ($T_{L30}$ bis $T_{L33}$, $T_{L3X}$, $T_{L3Y}$) und/oder die Basisvorwiderstände ($R_B$, $R_{B30}$, $R_{B40}$) der Teil-Treibertransistoren ($T_{T30}$, $T_{T40}$) als Diffusionswiderstände gebildet sind.

11. Leistungstransistoranordnung nach Anspruch 1 bis 10, **dadurch gekennzeichnet**, daß Leitbahnen über die diffundierten Widerstände ($R_{E1}$ bis $R_{E8}$, $R_{T1}$ bis $R_{T4}$; $R_{E30}$ bis $R_{E33}$, $R_{E3X}$, $R_{E3Y}$, $R_{T30}$, $R_{T40}$, $R_B$, $R_{B30}$, $R_{B40}$, $R_{C30}$ bis $R_{C33}$, $R_{C3X}$, $R_{C34}$) hinwegführen.

## Claims

1. Power transistor arrangement comprising a plurality of component power transistors of one type ($T_{L1}$ to $T_{L8}$; $T_{L30}$ to $T_{L33}$, $T_{L3X}$, $T_{L3Y}$) having in each case an emitter resistor ($R_{E1}$ to $R_{E8}$; $R_{E30}$ to $R_{E33}$, $R_{E3X}$, $R_{E3Y}$), the output circuits of which power transistors are connected in parallel to output terminals (E, C), and comprising a plurality of component driver transistors of another type ($T_{T1}$ to $T_{T4}$; $T_{T30}$, $T_{T40}$) having parallel connected input circuits, the bases of which driver transistors are connected to the control terminal (B) of the arrangement, the emitters of which driver transistors are connected to the output terminal (E) of the arrangement, which terminal is connected to the collectors of the component power transistors ($T_{L1}$ to $T_{L8}$; $T_{L30}$ to $T_{L33}$, $T_{L3X}$, $T_{L3Y}$) and the collectors of which power tansistors are connected to the bases of the component power transistors ($T_{L1}$ to $T_{L8}$; $T_{L30}$ to $T_{L33}$, $T_{L3X}$, $T_{L3Y}$), characterized in that the component power transistors ($T_{L1}$ to $T_{L8}$; $T_{L30}$ to $T_{L33}$, $T_{L3X}$, $T_{L3Y}$) and the component driver transistors ($T_{T1}$ to $T_{T4}$; $T_{T30}$, $T_{T40}$) are subdivided into individual, mutually assigned segments ($T_{T1}$, $T_{L1}$, $T_{L2}$; $T_{T2}$, $T_{L3}$, $T_{L4}$; $T_{T3}$, $T_{L5}$, $T_{L6}$; $T_{T4}$, $T_{L7}$, $T_{L8}$; $T_{T30}$, $T_{L30}$ to $T_{L33}$, $T_{L3X}$,

$T_{L3Y}$) having separate base current supply leads for the power transistor segments ($T_{L1}$, $T_{L2}$; $T_{L3}$, $T_{L4}$; $T_{L6}$; $T_{L7}$, $T_{L8}$; $T_{L30}$ to $T_{L33}$, $T_{L3X}$, $T_{L3Y}$).

2. Power transistor arrangement according to Claim 1, characterized in that each driver transistor segment has a component driver transistor ($T_{T1}$, $T_{T2}$, $T_{T3}$, $T_{T4}$; $T_{T30}$, $T_{T40}$) and each power transistor segment has at least one component power transistor ($T_{L1}$, $T_{L2}$; $T_{L3}$, $T_{L4}$; $T_{L5}$, $T_{L6}$; $T_{L7}$, $T_{L8}$; $T_{L30}$ to $T_{L33}$, $T_{L3X}$, $T_{L3Y}$).

3. Power transistor arrangement according to Claim 1 or 2, characterized in that each driver transistor segment is matched to the assigned power transistor segment.

4. Power transistor arrangement according to Claims 1 to 3, characterized in that the component driver transistors ($T_{T1}$, $T_{T2}$, $T_{T3}$, $T_{T4}$; $T_{T30}$, $T_{T40}$) are connected via emitter resistors ($R_{E1}$, $R_{E2}$, $R_{E3}$, $R_{E4}$; $R_{E30}$, $R_{E40}$) to the output terminal (E) of the arrangement, which terminal is connected to the collectors of the component power transistors ($T_{L1}$ to $T_{L8}$; $T_{L30}$ to $T_{L33}$, $T_{L3X}$, $T_{L3Y}$).

5. Power transistor arrangement according to Claims 1 to 4, characterized in that the emitters of the component driver transistors ($T_{T1}$ to $T_{T4}$; $T_{T30}$, $T_{T40}$) and the collectors of the component power transistors ($T_{L1}$ to $T_{L8}$; $T_{L30}$ to $T_{L33}$, $T_{L3X}$, $T_{L3Y}$) are connected via separate conducting tracks in each case to the corresponding output terminal (E) of the arrangement.

6. Power transistor arrangement according to Claims 1 to 5, characterized in that the emitters of the component driver transistors ($T_{T1}$ to $T_{T4}$; $T_{T30}$, $T_{T40}$) and the collectors of the component power transistors ($T_{L1}$ to $T_{L8}$; $T_{L30}$ to $T_{L33}$, $T_{L3X}$, $T_{L3Y}$) are in each case connected via a common conducting track, which branches to the individual power transistor, to the corresponding output terminal (E) of the arrangement.

7. Power transistor arrangement according to Claims 1 to 6, characterized in that the emitter resistors ($R_{E1}$ to $R_{E8}$; $R_{T1}$ to $R_{T4}$; $R_{E30}$ to $R_{E33}$, $R_{E3X}$, $R_{E3Y}$, $R_{T30}$, $R_{T40}$) are formed as diffusion resistors and are arranged topologically in such a way that the conducting tracks of the collector supply leads of the component power transistors ($T_{L1}$ to $T_{L8}$; $T_{L30}$ to $T_{L33}$, $T_{L3X}$, $T_{L3Y}$) are routed away above them.

8. Power transistor arrangement according to Claims 1 to 7, characterized in that the collectors of the component power transistors ($T_{L30}$ to $T_{L33}$, $T_{L3X}$, $T_{L3Y}$) are connected via collector resistors ($R_{C30}$ to $R_{C33}$, $R_{C3X}$, $R_{C3Y}$) to the corresponding output terminal (E) of the arrangement.

9. Power transistor arrangement according to Claims 1 to 8, characterized in that the bases of the component driver transistors ($T_{T30}$, $T_{T40}$) are connected via base series resistors ($R_B$, $R_{B30}$, $R_{B40}$) to the control terminal (B) of the arrangement.

10. Power transistor arrangement according to Claims 1 to 9, characterized in that the collector resistors ($R_{C30}$ to $R_{C33}$, $R_{C3X}$, $R_{C3Y}$) of the component power transistors ($T_{L30}$ to $T_{L33}$, $T_{L3X}$, $T_{L3Y}$) and/or the base series resistors ($R_B$, $R_{B30}$, $R_{B40}$) of the component driver resistors ($T_{T30}$, $T_{T40}$) are formed as diffusion transistors.

11. Power transistor arrangement according to Claims 1 to 10, characterized in that conducting tracks are routed away above the diffused resistors ($R_{E1}$ to $R_{E8}$, $R_{T1}$ to $R_{T4}$; $R_{E30}$ to $R_{E33}$, $R_{E3X}$, $R_{E3Y}$, $R_{T30}$, $R_{T40}$, $R_B$, $R_{B30}$, $R_{B40}$, $R_{C30}$ to $R_{C33}$, $R_{C3X}$, $R_{C3Y}$).

## Revendications

1. Dispositif formant transistor de puissance comportant plusieurs transistors élémentaires de puissance d'un type ($T_{L1}$ à $T_{L8}$; $T_{L30}$ à $T_{L33}$, $T_{L3X}$, $T_{L3Y}$) comportant chacun une résistance d'émetteur ($R_{E1}$ à $R_{E8}$; $R_{E30}$ à $R_{E33}$, $R_{E3X}$, $R_{E3Y}$), dont les circuits de sortie sont branchés en parallèle aux bornes de sortie (E, C) du dispositif, et plusieurs transistors élémentaires d'attaque de l'autre type ($T_{T1}$ à $T_{T4}$; $T_{T30}$, $T_{T40}$) comportant des circuits d'entrée branchés en parallèle et dont les bases sont raccordées à la borne de commande (B) du dispositif, dont les émetteurs sont raccordés à la borne de sortie (E) du dispositif, raccordée aux collecteurs des transistors élémentaires de puissance ($T_{L1}$ à $T_{L8}$, $T_{L30}$ à $T_{L33}$, $T_{L3X}$, $T_{L3Y}$) et dont les collecteurs sont reliés aux bases des transistors élémentaires de puissance ($T_{L1}$ à $T_{L8}$; $T_{L30}$ à $T_{L33}$, $T_{L3X}$, $T_{L3Y}$), caractérisé par le fait que les transistors élémentaires de puissance ($T_{L1}$ à $T_{L8}$, $T_{L30}$ à $T_{L33}$, $T_{L3X}$, $T_{L3Y}$) et les transistors élémentaires d'attaque ($T_{T1}$ à $T_{T4}$, $T_{T30}$, $T_{T40}$) sont subdivisés en des segments individuels réciproquement associés ($T_{T1}$, $T_{L1}$, $T_{L2}$, $T_{T2}$, $T_{L3}$, $T_{L4}$; $T_{T3}$, $T_{L5}$, $T_{L6}$; $T_{T4}$, $T_{L7}$, $T_{L8}$; $T_{T30}$, $T_{L30}$ à $T_{L33}$, $T_{L3X}$, $T_{L3Y}$) comportant des alimentations séparées délivrant le courant de base pour les segments ($T_{L1}$, $T_{L2}$; $T_{L3}$, $T_{L4}$; $T_{L5}$, $T_{L6}$; $T_{L7}$, $T_{L8}$; $T_{L30}$ à $T_{L33}$, $T_{L3X}$, $T_{L3Y}$) d'un transistor de puissance.

2. Dispositif formant transistor de puissance suivant la revendication 1, caractérisé par le fait que chaque segment d'un transistor d'attaque comporte un transistor élémentaire d'attaque ($T_{T1}$, $T_{T2}$, $T_{T3}$, $T_{T4}$; $T_{T30}$, $T_{T40}$) et chaque segment d'un transistor de puissance comporte au moins un transistor élémentaire de puissance ($T_{L1}$, $T_{L2}$; $T_{L3}$, $T_{L4}$; $T_{L5}$, $T_{L6}$; $T_{L7}$, $T_{L8}$; $T_{L30}$ à $T_{L33}$, $T_{L3X}$, $T_{L3Y}$).

3. Dispositif formant transistor de puissance suivant la revendication 1 ou 2, caractérisé par le fait que chaque segment d'un transistor d'attaque est adapté au segment associé du transistor de puissance.

4. Dispositif formant transistor de puissance suivant les revendications 1 à 3, caractérisé par le fait que les transistors élémentaires d'attaque ($T_{T1}$, $T_{T2}$, $T_{T3}$, $T_{T4}$; $T_{T30}$, $T_{T40}$) sont reliés par l'intermédiaire de résistances d'émetteur ($R_{T1}$, $R_{T2}$, $R_{T3}$, $R_{T4}$; $R_{T30}$, $R_{T40}$) à la borne de sortie (E) du dispositif, raccordée aux collecteurs des transistors élémentaires de puissance ($T_{L1}$ à $T_{L8}$; $T_{L30}$ à $T_{L33}$, $T_{L3X}$, $T_{L3Y}$).

5. Dispositif formant transistor de puissance suivant les revendications 1 à 4, caractérisé par le fait que les émetteurs des transistors élémentaires d'attaque ($T_{T1}$ à $T_{T4}$; $T_{T30}$, $T_{T40}$) et les collecteurs des transistors élémentaires de puissance ($T_{L1}$ à $T_{L8}$; $T_{L30}$ à $T_{L33}$, $T_{L3X}$, $T_{L3Y}$) sont reliés par l'intermédiaire de voies conductrices séparées, à la borne de sortie correspondante (E) du dispositif.

6. Dispositif formant transistor de puissance suivant les revendications 1 à 5, caractérisé par le fait que les émetteurs des transistors élémentaires d'attaque ($T_{T1}$ à $T_{T4}$; $T_{T30}$ à $T_{T40}$) et les collecteurs des transistors élémentaires de puissance ($T_{L1}$ à $T_{L8}$; $T_{L30}$ à $T_{L33}$, $T_{L3X}$, $T_{L3Y}$) sont reliés respectivement par l'intermédiaire d'une voie conductrice commune, qui se ramifie en les différents transistors partiels, à la borne de sortie correspondante (E) du dispositif.

7. Dispositif formant transistor de puissance suivant les revendications 1 à 6, caractérisé par le fait que les résistances d'émetteur ($R_{E1}$ à $R_{E8}$, $R_{T1}$ à $R_{T4}$; $R_{E30}$ à $R_{E33}$, $R_{E3X}$, $R_{E3Y}$, $R_{T30}$, $R_{T40}$) sont réalisées sous la forme de résistances de diffusion et sont disposées du point de vue topologique de telle sorte que les voies conductrices des alimentations des collecteurs des transistors élémentaires de puissance ($T_{L1}$, $T_{L8}$; $T_{L30}$ à $T_{L33}$, $T_{L3X}$, $T_{L3Y}$) incluent ces résistances.

8. Dispositif formant transistor de puissance suivant les revendications 1 à 7, caractérisé par le fait que les collecteurs des transistors élémentaires de puissance ($T_{L30}$ à $T_{L33}$, $T_{L3X}$, $T_{L3Y}$) sont reliés, par l'intermédiaire de résistances de collecteur ($R_{C30}$ à $R_{C33}$, $R_{C3X}$, $R_{C3Y}$) à la borne de sortie correspondante (E) du dispositif.

9. Dispositif formant transistor de puissance suivant les revendications 1 à 8, caractérisé par le fait que les bases des transistors élémentaires d'attaque ($R_{T30}$, $R_{T40}$) sont reliés, par l'intermédiaire de résistances additionnelles de base ($R_B$, $R_{B30}$, $R_{B40}$) à la borne de commande (B) du dispositif.

10. Dispositif formant transistor de puissance suivant les revendications 1 à 9, caractérisé par le fait que les résistances de collecteur ($R_{C30}$) des transistors élémentaires de puissance ($T_{L30}$ à $T_{L33}$, $T_{L3X}$, $T_{L3Y}$) et/ou les résistances additionnelles de base ($R_B$, $R_{B30}$, $R_{B40}$) des transistors élémentaires d'attaque ($T_{T30}$, $T_{T40}$) sont réalisées sous la forme de résistances de diffusion.

11. Dispositif formant transistor de puissance suivant les revendications 1 à 10, caractérisé par le fait que les voies conductrices incluent les résistances diffusées ($R_{E1}$ à $R_{E8}$; $R_{T1}$ à $R_{T4}$; $R_{E30}$ à $R_{E33}$, $R_{E3X}$, $R_{E3Y}$, $R_{T30}$, $R_{T40}$, $R_B$, $R_{B30}$, $R_{B40}$, $R_{C30}$ à $R_{C33}$, $R_{C3X}$, $R_{C3Y}$).

FIG 1

FIG 2

FIG 3